# EUROPÄISCHE PATENTSCHRIFT

(11) **EP 0 980 445 B1**
(45) Veröffentlichungstag und Bekanntmachung des Hinweises auf die Patenterteilung: **19.11.2003**
(21) Anmeldenummer: 98933442.0
(22) Anmeldetag: 02.05.1998
(51) Int. Cl.: C23C 16/36, C23C 16/34, C23C 16/32

(54) **SCHNEIDEINSATZ ZUM ZERSPANEN UND VERFAHREN ZUR HERSTELLUNG DIESES SCHNEIDEINSATZES**
PROCESSING INSERT, AND PRODUCTION OF SAME
OUTIL RAPPORTE D'USINAGE, ET SON PROCEDE DE FABRICATION

(30) Priorität: 09.05.1997 DE 19719195
(43) Veröffentlichungstag der Anmeldung: 23.02.2000
(73) Patentinhaber: Widia GmbH, 45145 Essen (DE)
(72) Erfinder: KÖNIG, Udo, D-45149 Essen (DE); VAN DEN BERG, Hendrikus, NL-5925 BT Venlo-Blerick (NL); WESTPHAL, Hartmut, D-36466 Dermbach (DE); SOTTKE, Volkmar, D-45479 Mülheim (DE)
(74) Vertreter: Vomberg, Friedhelm, Dipl.-Phys.
(86) Internationale Anmeldenummer: DE9801237
(87) Internationale Veröffentlichungsnummer: WO98051839

(56) Entgegenhaltungen:
- EP-A- 0 032 887
- EP-A- 0 665 308
- DD-A- 288 630
- FR-A- 2 171 334
- US-A- 4 714 660
- PATENT ABSTRACTS OF JAPAN vol. 014, no. 003 (M-915), 8. Januar 1990 -& JP 01 252305 A (MITSUBISHI METAL CORP), 9. Oktober 1989
- PATENT ABSTRACTS OF JAPAN vol. 010, no. 166 (C-353), 13. Juni 1986 -& JP 61 019777 A (SUMITOMO DENKI KOGYO KK), 28. Januar 1986
- PATENT ABSTRACTS OF JAPAN vol. 017, no. 595 (M-1503), 29. Oktober 1993 -& JP 05 177412 A (SUMITOMO ELECTRIC IND LTD), 20. Juli 1993
- PATENT ABSTRACTS OF JAPAN vol. 005, no. 058 (C-051), 21. April 1981 & JP 56 009366 A (HITACHI METALS LTD), 30. Januar 1981

## Beschreibung

Die Erfindung betrifft einen Schneideinsatz zum Zerspanen, bestehend aus einem Hartmetall-, Cermet- oder Keramik-Substratkörper mit einer mehrlagigen Beschichtung.

Mit Hartstoff, ggf. auch mehrlagig beschichtete Substratkörper sind nach dem Stand der Technik bekannt. Die Hartstoffbeschichtung soll im Regelfall dazu dienen, eine verschleißbeständige Oberflächenschicht zu schaffen, die mit zähen, mechanisch hoch belasteten Substratkörpern kombiniert wird. Nach dem Stand der Technik werden zur Beschichtung zwei verschiedene Verfahren verwendet, nämlich die sogenannte Chemical Vapour Deposition (CVD) oder die Physical Vapour Deposition (PVD) angewendet. Übliche Schutzschichten bestehen beispielsweise aus TiC, TiN und/oder Aluminiumoxid. Es sind auch bereits Mehrlagenbeschichtungen mit der Schichtfolge TiN, Ti(C,N), Ti(C,N), TiN auf einem Substratkörper mit beliebigem C:N-Mischungsverhältnissen vorgeschlagen worden.

Aus der DE 195 30 517 A1 sind auch Metallcarbonitrid-Hartstoffschichten auf einem Substratkörper bekannt, bei denen das Metall der Metallcarbonitridschicht zwei oder mehrere Elemente der Gruppe Ti, Zr, Hf, V, Nb, Ta, Cr, Mo und W enthält. Die Schicht wird durch CVD, insbesondere in Form einer quaternären Schicht aus (Ti,Zr)(C,N) beschrieben. Als spezielles Ausführungsbeispiel für eine Wendeschneidplatte wurde eine Beschichtung aus einer ca. 1 µm dicken TiN-Schicht, einer 8 µm dicken Schicht aus einem (Ti,Zr)(C,N) und einer letzten, zwischen 1 bis 5 µm dicken Al₂O₃-Schicht auf einem Hartmetall-Substratkörper abgeschieden.

Die bereits erwähnten PVD-Beschichtungen, die bereits ab ca. 400°C hergestellt werden können, werden zumeist bei temperaturempfindlichen Substratkörpern verwendet, insbesondere zur Beschichtung von Schnellarbeitsstählen, die während der Beschichtung nicht temperaturbelastet werden sollen.

Die JP 01-252305 beschreibt einen Hartmetall-Substratkörper mit einer mehrlagigen Beschichtung, deren innere Schicht entweder aus Titancarbid oder aus mehreren Lagen gebildet werden soll, die aus Carbiden, Carbonitriden, Carbooxiden oder Carbooxinitriden des Titans, Zirkoniums oder Hafniums oder aus Al₂O₃ bestehen. Die äußere Schicht soll entweder aus Titannitrid oder aus mehreren Lagen gebildet werden, die jeweils aus Titannitrid und/oder einem Carbid, Carbonitrid, Carbooxinitrid oder Carbooxid des Titans, Zirkoniums oder Hafniums bestehen. Die genannte innere Schicht soll mittels eines CVD-Verfahrens und die äußere Schicht mittels eines PVD-Verfahrens aufgetragen werden.

Die JP 61-197777 beschreibt ebenfalls einen beschichteten Hartmetallkörper, bei dem eine innere Schicht aus einem Carbid und/oder Carbonitrid des Titans, Zirkoniums und Hafniums, eine Zwischenlage aus Al₂O₃ und/oder ZrO₂ und eine Deckschicht aus einem Nitrid und/oder Carbonitrid des Zirkoniums und/oder Hafniums aufgetragen worden ist.

Weiterhin sind aus der EP 0 032 887 A1 Beschichtungen aus Titancarbid und Aluminiumoxid bzw. Titancarbid, Titancarbonitrid und Aluminiumoxid bekannt.

Den inhaltsgleichen Druckschriften WO 92/05296 oder US 5 143 488 ist darüber hinaus zu entnehmen, daß durch CVD-Verfahren abgeschiedene TiN-Beschichtungen Zugspannungen aufweisen, während durch PVD-Verfahren aufgetragene TiN-Beschichtungen Druckspannungen aufweisen, die nicht wie Zugspannungen zu Rissen führen. Zur Verbesserung der Bruchfestigkeit wird daher in diesen Druckschriften vorgeschlagen, eine oder mehrere CVD-Schicht bzw. -Schichten mit einer oder mehreren durch PVD abgeschiedenen Schichten zu kombinieren. Als Material für die innere, mittels CVD-abgeschiedene Schicht werden Nitride des Titans, Hafniums und/oder Zirkoniums und für die mittels PVDabgeschiedene Schicht Nitride und Carbonitride der genannten Metalle vorgeschlagen. Verfahrenstechnisch besteht der Nachteil, daß aufeinanderfolgend zwei relativ aufwendige unterschiedliche Beschichtungen (CVD, PVD) in unterschiedlichen Apparaturen durchgeführt werden müssen. Darüber hinaus hat sich herausgestellt, daß die mehrlagige Beschichtung aus mittels CVD-abgeschiedenen inneren Schichten und mindestens einer äußeren mittels PVD-abgeschiedenen Schicht bei größeren Schichtdicken zum Abplatzen neigen.

Es ist daher Aufgabe der vorliegenden Erfindung, die vorgenannten Nachteile zu vermeiden. Der Schneideinsatz soll bis hin zu relativ großen Schichtdicken eine hohe Bruchzähigkeit (Biegebruchfestigkeit) aufweisen. Das zu seiner Herstellung benötigte Verfahren soll mit möglichst geringem apparativen Aufwand kostengünstig durchführbar sein.

Diese Aufgabe wird durch einen Schneideinsatz nach Anspruch 1 gelöst.

Die mehrlagige Beschichtung auf einem Hartmetall-, Cermet- oder Keramik-Substratkörper besitzt eine äußere Schicht (Deckschicht), die aus einer ein- oder mehrphasigen Schicht aus Carbiden, Nitriden oder Carbonitriden auf Zirkonium- oder Hafnium-Basis besteht und die innere Druckspannungen aufweist. Die darunterliegende Schicht oder Schichten weisen ausnahmslos innere Zugspannungen auf, wobei mindestens eine oder die einzige darunterliegende Schicht aus Titannitrid, Titancarbid und/oder Titancarbonitrid besteht. Wesentlich für die vorliegende Erfindung ist, daß die Deckschicht jeweils als Carbid, Nitrid oder Carbonitrid gebundenes Zirkonium oder Hafnium enthält und mit einer darunterliegenden Schicht aus einem Titancarbid, -nitrid und/oder -carbonitrid kombiniert wird. Bevorzugt liegen die Druckspannungen zwischen -500 bis -2500 MPa (Druckspannungen werden definitionsgemäß mit negativen Werten im Gegensatz zu Zugspannungen, für die positive Werte angesetzt werden, benannt).

Insbesondere kann als einphasige Deckschicht ein Carbid, Nitrid oder Carbonitrid des Zirkoniums oder Hafniums gewählt werden. Alternativ hierzu sind jedoch auch einphasige Deckschichten aus einem Carbid, Nitrid oder Carbonitrid der Form (M₁,M₂)(CₓN₁₋ₓ) mit M₁ = Zr oder Hf und M₂ = Ti, Hf, Nb besteht, wobei 0 ≤ x ≤ 1 ist. im letzteren Fall spricht man auch von sogenannten quaternären Multimetall-Carbonitriden.

Eine bevorzugte zweiphasige äußere Schicht besteht aus einem Carbid, Nitrid oder Carbonitrid des Zirkoniums oder Hafniums und ZrO₂. ZrO₂ kann in monokliner, tetragonaler und/oder kubischer Modifikation vorliegen. Insbesondere kann die äußere Schicht eine Zusammensetzung der Form Me(CₓN₁₋ₓ) mit Me = Zr oder Hf und 0,3 ≤ x ≤ 0,7 enthalten. Ist die Deckschicht eine einphasige Schicht, so unterscheidet sie sich von der zweiphasigen Schicht dadurch, daß sie eine einheitliche Struktur und Gitterkonstante aufweist, was insbesondere tertiäre und quaternäre Carbide,

Nitride oder Carbonitride einschließt, bei denen Zirkonium oder Hafnium allein oder insgesamt zu mindestens 50 Atom% vorhanden sein müssen. Die betreffenden Metallatome verteilen sich dann statistisch auf einem Untergitter, während deren Metalloide Kohlenstoff und Stickstoff ebenfalls ungeordnet auf dem anderen Untergitter verteilt sind.

Bei einer zweiphasigen Schicht, die insbesondere aus einem Carbid, Nitrid oder Carbonitrid des Zirkoniums oder Hafniums besteht und zusätzlich ZrO₂ aufweist, bestehen nebeneinander zwei hinsichtlich der Kristallstruktur und des Gitters unterschiedliche Phasen. Die zweite Phase ZrO₂ liegt vorzugsweise mit einem relativen Anteil zwischen 15 und 60 Massen% vor.

Nach einer weiteren Ausgestaltung der Erfindung kann zusätzlich zwischen der Deckschicht und mindestens einer substratkörpernahen Schicht eine der unteren Lagen aus Al₂O₃ bestehen.

Bevorzugte Dicken der Deckschicht liegen zwischen 2 µm und maximal 10 µm, wobei weiterhin vorzugsweise die Gesamtdicke der aus der inneren, unter Zugspannung stehenden, und der äußeren, unter Druckspannung stehenden Schichten zwischen 5 und 25 µm, insbesondere zwischen 10 und 20 µm liegt.

Bevorzugt wird eine erste auf dem Substratkörper abgeschiedene TiN-Schicht mit einer Dicke bis 2 µm und eine oder mehrere TiCN-Schichten bis 5 µm, worauf eine bis 5 µm dicke einphasige oder zweiphasige Deckschicht abgeschieden worden ist.

Zur Herstellung eines Schneideinsatzes der vorgenannten Art wird die Beschichtung durch einen ununterbrochenen CVD-Prozeß bei Temperaturen zwischen 900°C und 1100°C durch jeweilige Wechsel der Gaszusammensetzungen aufgetragen.

Die Druckspannung einer äußeren Schicht aus einem einphasigen Multimetall-Carbonitrid läßt sich insbesondere dadurch steigern, daß nach der CVD-Abscheidung eine Wärmebehandlung einer höherer Temperatur als derjenigen Substratkörpertemperatur bei der letzten Abscheidung anschließt. Die betreffenden Temperaturen liegen zwischen 950°C und unterhalb der eutektischen Temperatur des Substratkörperwerkstoffes. Die Wärmebehandlung dauert mindestens 15 Minuten, so daß eine spinodale Entmischung in eine titanreiche und eine zirkonreiche Phase stattfindet.

Vorzugsweise wird die Beschichtung nach Abschluß des CVD-Prozesses einer zusätzlichen, die Oberfläche glättenden mechanischen Behandlung durch schmirgelnde Bürsten oder durch trockenes oder nasses Strahlen mit feinem Strahlmittel, vorzugsweise Glaskugeln oder Korund unterworfen.

Die Erfindung wird im folgenden anhand von Ausführungsbeispielen näher erläutert.

In CVD-Versuchen wurden verschiedene, in der Tabelle 1 zusammengestellte Beschichtungen auf Wendeschneidplatten aus einem Hartmetall aufgebracht. An diesen Beschichtungen wurden durch eine Meßmethode mit Röntgenstrahlen (sogenannte sin²ψ-Methode) die Spannungen in der an die Oberfläche grenzenden Schicht gemessen. Zum Vergleich sind in Tabelle 1 auch Meßwerte von durch PVD hergestellte TiN- und TiC-Schichten (siehe Beispiele 1 und 2) aufgeführt. Diese durch PVD abgeschiedenen Schichten wiesen die nach dem Stand der Technik bekannten hohen Druckeigenspannungen auf, während die mittels CVD abgeschiedenen TiN-, TiC- und Ti(C,N)-Schichten gemäß Beispielen 3 bis 5 unterschiedlich große Zugspannungen aufweisen, was ebenfalls nach dem Stand der Technik bekannt ist. Demgegenüber sind in Beispielen 6 bis 8 erfindungsgemäße Beschichtungen aufgeführt, nämlich jeweils eine innere Schicht aus Ti(C,N) und eine Deckschicht aus Zr(C_{0,49}N_{0,51}) (Beispiel 6), eine zweiphasige Schicht aus Zr(C_{0,5}N_{0,5})/ZrO₂ (Beispiel 7) und eine Deckschicht aus Hf(C_{0,5}N_{0,5}).

Eigenschaften von Hartstoffschichten, wobei mit positiven Vorzeichen Zugspannungen und negativen Vorzeichen Druckspannungen angegeben werden:

**Tabelle 1**

| Beispiel Nr. | Schichtzusammensetzung | Eigenspannung MPa | Methode |
|---|---|---|---|
| (1) | TiN | - 3100 | PVD |
| (2) | TiC | - 3800 | PVD |
| (3) | TiN | + 300 | CVD |
| (4) | TiC | + 50 | CVD |
| (5) | Ti(C_{0,46}N_{0,54}) | + 550 | CVD |
| (6) | Ti(C,N)+Zr(C_{0,49}N_{0,51}) | - 1250 | CVD |
| (7) | Ti(C,N)+Zr(C_{0,5}N_{0,5})ZrO₂ | - 1600 | CVD |
| (8) | Ti(C,N)+Hf(C_{0,5}N_{0,5}) | - 1020 | CVD |

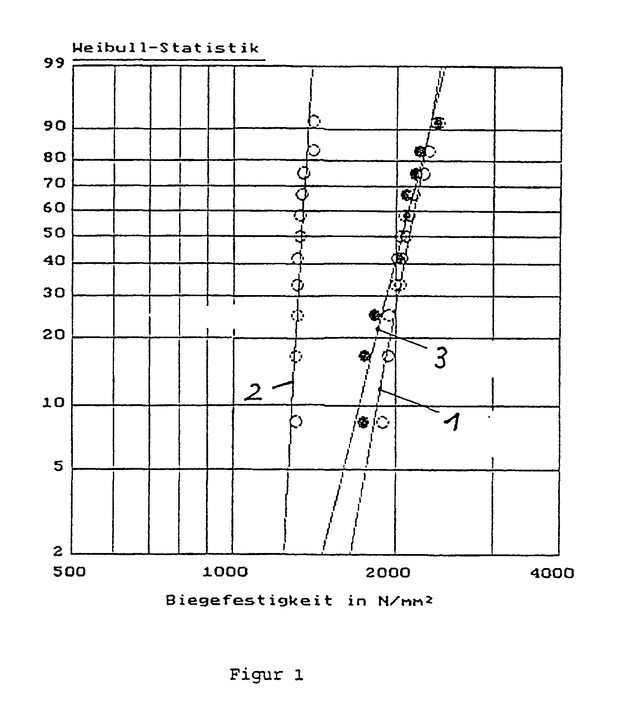

Zum Nachweis der verbesserten Zähigkeit der erfindungsgemäßen beschichteten Hartmetallkörper wurden Probekörper nach der Norm DIN ISO 3327 aus einer Hartmetallegierung (83,5 Massen% WC, 11 Massen% (Ti,Ta,Nb)C, 5,5 Massen% Co) hergestellt. Die Probekörper mit den Abmessungen L x H x B = 20 x 5,25 x 6,5 mm dienten zur Bestimmung der Biegebruchfestigkeit. Ein Teil der Probekörper wurde in bekannter Weise durch CVD bei 1010°C mit einer Schicht aus Ti(C_{0,5}N_{0,5}) beschichtet. In einem anderen CVD-Prozeß wurde ein weiteres Los der Probekörper mit einer zweilagigen Schicht aus 8 µm Ti(C_{0,5}N_{0,5}) und 3 µm Zr(C_{0,5}N_{0,5}) versehen. Nach der Bestimmung der Schichtdicken wurden jeweils 11 Probekörper aus statistischen Gründen bis zum Bruch belastet. Die Ergebnisse sind in einer Weibull-Statistik in Fig. 1 dargestellt. Die Biegefestigkeit 1 der unbeschichteten Prüfkörper beträgt 2095 ± 150 N/mm². Durch eine ca. 8 µm dicke Beschichtung aus Ti(C_{0,5}N_{0,5}) wird die Biegefestigkeit 2 der Prüfkörper auf 1332 ± 34 N/mm² herabgesetzt. Dieser Effekt ist in der Literatur mehrfach beschrieben worden, beispielsweise in der US 5 143 488. Er ist um so größer, je dicker die Schicht ist.

Gleichfalls Fig. 1 ist die Biegefestigkeit 3 einer erfindungsgemäßen Beschichtung aus 8 µm Ti(C_{0,5}N_{0,5}) und 3 µm Zr(C_{0,5}N_{0,5}) dargestellt. In diesem Fall ist der Mittelwert der Biegefestigkeit 2021 ± 194 N/mm² nur wenig geringer als bei den unbeschichteten Proben. Dies bedeutet, daß die Bruch-zähigkeit des erfindungsgemäß beschichteten Verbundkörpers praktisch vollständig erhalten bleibt.

Weiterhin wurden Wendeschneidplatten des Typs CNMG120412-5 aus einer Hartmetallegierung mit der Zusammensetzung 83,5 Massen% WC, 11 Massen% (Ti,Ta,Nb)C, 5,5 Massen% Co hergestellt und mit den mit den in Tabelle 1 spezifizierten Schichtfolgen (5) und (6) durch CVD-Prozesse beschichtet. Mit diesen Schneideinsätzen wurden Zerspanungsversuche durchgeführt. Das Zähigkeitsverhalten wurde in einem Bolzendrehtest nach Brechbühl untersucht. Hierbei handelt es sich um ein stirnseitiges Plandrehen von vier parallel zur Drehachse angeordneten Rundstäben von 40 mm Durchmesser aus dem Stahl C45N (570 N/mm²). Pro Umdrehung wird die Schneidecke mit vier Einschnitten in den Werkstoff belastet. Nach jeweils drei Überläufen wird der Vorschub f systematisch erhöht. Weitere Schnittparameter sind Schnittgeschwindigkeit v_{c} = 250 m/min und Schnittiefe aₚ = 2 mm. Dieser Test stellt ganz besondere Anforderungen an die Bruchzähigkeit des Verbundkörpers aus Hartmetall und Beschichtung. Die Ergebnisse dieses Tests sind in Tabelle 2 zusammengestellt.

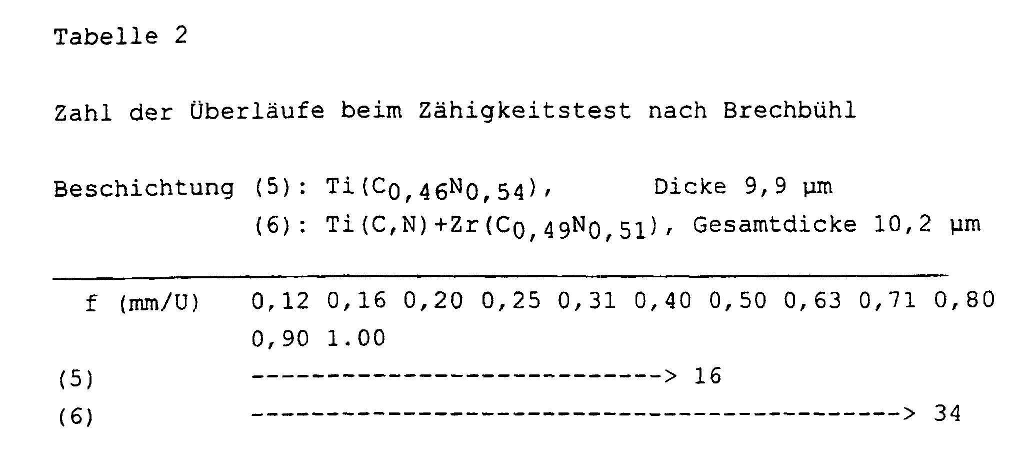

Die Wendeschneidplatte mit der Beschichtung (5) nach dem Stand der Technik versagte wegen Bruch der Schneide bei einem Vorschub von f = 0,40 mm/U nach 16 Überläufen. Die Wendeschneidplatte mit der erfindungsgemäßen Beschichtung (6) erreichte 34 Überläufe bei der Planung der Stirnflächen.

In einem weiteren Anwendungsbeispiel ist eine Wendeschneidplatte des Typs DNMG150612-22, bestehend aus einer Cermet-Legierung HT-P15 mit einer CVD-Beschichtung überzogen worden, deren Gesamtdicke 14,3 µm betrug. Diese CVD-Beschichtung setzte sich aus der Schichtfolge 1,1 µm TiN, 7,9 µm Ti(C,N), 2,3 µm -Al₂O₃ und als abschließender Außenlage 2,1 µm Zr(C,N) zusammen. Als Vergleichsplatte ist eine Wendeschneidplatte desselben Typs DNMG150612-22, bestehend aus einem beschichteten Cermet-Substratkörper hergestellt worden. Der Substratkörper bestand ebenfalls aus einer Cermet-Legierung HT-P15 und besaß eine CVD-Beschichtung mit einer Gesamtdicke von 14,9 µm, welche die Schichtfolge 3,1 µm TiN, 8,9 µm Ti(C,N) und 2,9 µm TiN als Außenlage aufweist. Beide Platten sind zum Drehen eines Flansches im glatten Schnitt aus einem Stahl 20NiMoCr65 unter Anwendung eines Kühlschmierstoffes bei Schnittgeschwindigkeiten von 360 m/min, Schnittiefe von 2,0 mm und einem Vorschub von 0,25 mm/U eingesetzt worden. Der erfindungsgemäße Schneidkörper mit der äußeren Zr(C,N) besaß eine Standzeit von 315 bearbeiteten Teilen, während mit dem Vergleichskörper nur 213 Teile bearbeitet werden konnten. Dies zeigt, daß eine mehr als 50 %ige Standzeitverbesserung mit dem erfindungsgemäß beschichteten Cermet-Substratkörper erzielt werden kann.

In einem weiteren Anwendungsbeispiel sind beschichtete Hartmetall-Wendeschneidplatten verglichen worden.

Die der Erfindung entsprechende Wendeschneidplatte vom Typ CNMG120408-49 besaß einen Hartmetall-Substratkörper der Zusammensetzung 86,5 % WC, 8 % (Ti,Ta,Nb)C, 5,5 % Co. Die CVD-Beschichtung mit einer Gesamtdicke von 14,8 µm setzte sich aus der Schichtfolge 1 µm TiN, 9,3 µm Ti(C,N), 2,1 µm Al₂O₃ und 2,4 µm Zr(C,N) als Außenlage zusammen.

Als Vergleichs-Wendeschneidplatte desselben Typs CNMG120408 ist ein beschichteter Hartmetallkörper verwendet worden, dessen Substratkörper eine Zusammensetzung bestehend aus 5,57 % Co, 3,49 % TaC, 2,27 % NbC, 2,59 % TiC sowie Spuren von Fe, Mo, Cr, Rest WC aufwies. Dieser Substratkörper war mit einer CVD-Beschichtung in einer Gesamtdicke von 15,1 µm versehen, wobei die sich auf dem Substratkörper befindende 6,8 µm dicke TiC-Schicht mit einer Al₂O₃-Außenlage einer Dicke von 8,3 µm überzogen war.

Beide vorgenannten Wendeschneidplatten sind zum Drehen eines Maschinenteiles mit Schnittunterbrechungen aus dem Stahl 42CrMoV4MoW ohne Anwendung von Kühlschmierstoffen bei Schnittgeschwindigkeiten von 51 m/min, Schnittiefen von 2,0 mm und einem Vorschub von 0,15 mm/U eingesetzt worden. Während mit dem erfindungsgemäßen Schneidkörper der CVD-Schichtfolge TiN-Ti(C,N)-Al₂O₃-Zr(C,N) sechs Teile fertig bearbeitet werden konnten, war die Vergleichswendeschneidplatte bereits nach zwei bearbeiteten Teilen unbrauchbar. Dies zeigt, daß mit dem erfindungsgemäß beschichteten Hartmetall eine dreimal so große Standzeit erzielbar ist.

## Patentansprüche

1. Schneideinsatz zum Zerspanen, bestehend aus einem Hartmetall-, Cermet- oder Keramik-Substratkörper mit einer mehrlagigen Beschichtung, deren äußere Schicht (Deckschicht) aus einer ein- oder mehrphasigen Schicht aus Carbiden, Nitriden oder Carbonitriden auf Zr- oder Hf-Basis besteht oder daß die äußere Schicht zweiphasig ist und aus einem Carbid, Nitrid oder Carbonitrid des Zr oder Hf und ZrO₂ besteht, die mittels CVD aufgetragen worden ist und die innere Druckspannungen aufweist und deren darunterliegende, ebenfalls mittels CVD aufgetragene Schicht(en) ausnahmslos innere Zugspannungen aufweist/aufweisen, wobei mindestens eine oder die einzige darunterliegende Schicht aus TiN, TiC und/oder Ti(C,N) besteht.

2. Schneideinsatz nach Anspruch 1, **dadurch gekennzeichnet, daß** eine zwischen der Deckschicht und mindestens einer substratkörpernahen Schicht liegende Schicht aus Al₂O₃ besteht.

3. Schneideinsatz nach Anspruch 1 oder 2, **dadurch gekennzeichnet, daß** die äußere Schicht einphasig ist und aus einem Carbid, Nitrid oder Carbonitrid des Zr oder Hf oder aus einem Carbid, Nitrid oder Carbonitrid der Form (M₁,M₂)(CₓN₁₋ₓ) mit M₁ = Zr oder Hf und M₂ = Ti, Hf, Nb besteht und 0 ≤ x ≤ 1 ist.

4. Schneideinsatz nach einem der Ansprüche 1 bis 3, **dadurch gekennzeichnet, daß** die äußere Schicht eine Zusammensetzung Me(CₓN₁₋ₓ) mit Me = Zr oder Hf und
0,3 ≤ x ≤ 0,7 enthält, wobei vorzugsweise die äußere Schicht zusätzlich als zweite Phase ZrO₂ mit einem relativen Anteil zwischen 15 und 60 Massen% enthält.

5. Schneideinsatz nach einem der Ansprüche 1 bis 4, **dadurch gekennzeichnet, daß** die Deckschicht eine Dicke von mindestens 2 µm und maximal 10 µm aufweist und/oder daß die Gesamtdicke der aus inneren, unter Zugspannung stehenden und der aus äußeren, unter Druckspannung stehenden Schicht(en) zwischen 5 und 25 µm, vorzugsweise zwischen 10 und 20 µm, liegt.

6. Schneideinsatz nach einem der Ansprüche 1, 3 oder 5, **gekennzeichnet durch** eine auf dem Substratkörper abgeschiedene Schichtfolge TiN mit einer Dicke bis 2 µm, TiCN mit einer Dicke bis 5 µm und der bis 5 µm dicken einphasigen oder zweiphasigen Deckschicht.

7. Verfahren zur Herstellung eines Schneideinsatzes nach einem der Ansprüche 1 bis 6, **dadurch gekennzeichnet, daß** die Beschichtung durch einen ununterbrochenen CVD-Prozeß bei Temperaturen zwischen 900°C und 1100°C durch jeweilige Wechsel der Gaszusammensetzungen aufgetragen wird.

8. Verfahren zur Herstellung eines Schneideinsatzes aus einem Hartmetall-, Cermet- oder Keramiksubstratkörper mit einer mehrlagigen Beschichtung, deren äußere Schicht aus einem einphasigen Multimetall-Carbonitrid besteht, die mittels CVD aufgetragen wird und die innere Druckspannungen aufweist und deren darunterliegende, ebenfalls mittels CVD aufgetragene Schicht(en) ausnahmslos innere Zugspannungen aufweist/aufweisen, wobei nach Abscheidung der äußeren Schicht diese Schicht durch eine Wärmebehandlung oberhalb der letzten CVD-Abscheidetemperatur und unterhalb der eutektischen Temperatur des Substratkörpers über mindestens 15 min ausgesetzt wird, wodurch eine spinodale Entmischung entsteht.

9. Verfahren nach Anspruch 8, **dadurch gekennzeichnet, daß** die Wärmebehandlung zwischen 1000°C und 1200°C, vorzugsweise in einer Schutzgasatmosphäre erfolgt.

10. Verfahren nach einem der Ansprüche 7 bis 9, **dadurch gekennzeichnet, daß** die Beschichtung (Deckschicht) nach Abschluß des CVD-Prozesses einer zusätzlichen, die Oberfläche glättenden mechanischen Behandlung durch schmirgelnde Bürsten oder durch trockenes oder nasses Strahlen mit feinem Strahlmittel, vorzugsweise aus Glaskugeln oder Korund, unterworfen wird.

## Claims

1. Cutting insert for machining operations consisting of a hard metal, a cermet or a ceramic substrate body with a multilayer coating, whose outer layer (cover layer) consists of a single-phase or multiphase layer of carbides, nitrides or carbonitrides on Zr- or Hf-basis, or that the outer layer is two-phased and consists of a carbide, nitride or carbonitride of Zr or Hf and ZrO₂, which was applied by means of CVD and presents inner compressive strains, and its underlying layer(s) applied also by CVD has/have exclusively inner tensile TiC strains, whereby at least one or the sole underlying layer consists of TiN, TiC and/or Ti(C,N).

2. Cutting insert according to claim 1, **characterized in that** a layer lying between the cover layer and at least one layer close to the substrate body consists of Al₂O₃.

3. Cutting insert according to claim 1 or 2, **characterized in that** the outer layer is single-phased and consists of a carbide, nitride or carbonitride of Zr or Hf or consists of a carbide, nitride or carbonitride of the form (M₁, M₂) (CₓN₁₋ₓ) with M₁ = Zr or Hf and M₂ = Ti, Hf, Nb and 0 ≤x ≤1.

4. Cutting insert according to one of claims 1 to 3, **characterized in that** the outer layer contains a composition Me(CₓN₁₋ₓ) with Me = Zr or Hf and 0,3 ≤x ≤7, whereby the outer layer contains additionally as a second phase ZrO₂ with a relative proportion of 15 and 60 % by mass.

5. Cutting insert according to one of claims 1 to 4, **characterized in that** the cover layer has a thickness of at least 2 µm and a maximum of 10 µm and/or that the total thickness of the inner layer(s) subjected to tensile strains and of the outer layer(s) subjected to compressive strains ranges between 5 and 25 µm, preferably between 10 and 20 µm.

6. Cutting insert according to one of claims 1, 3 or 5, **characterized by** a layer sequence deposited on the substrate body of TiN with a thickness up to 2 µm, TiCN with a thickness up to 5 µm and the single-phase or two-phase cover layer with a thickness of up to 5 µm.

7. Method for producing a cutting insert according to claims 1 to 6, **characterized in that** the coating is applied through an uninterrupted CVD process at temperatures between 900°C and 1100°C, by respectively changing the gas composition.

8. Method for producing a cutting insert consisting of a hard metal, a cermet or a ceramic substrate body with a multilayer coating, whose outer layer consists of a sings-phased multimetal carbonitride which was applied by CVD and presents inner compressive strains, and its underlying layer(s) applied also by CVD has/have exclusively inner tensile strains, whereby after the deposition of the outer layer, this layer is subjected to a heat treatment above the last CVD deposition temperature and below the eutectic temperature of the substrate body for at least 15 minutes, whereby a spinodal segregation takes place.

9. Method according to claim 8, **characterized in that** the heat treatment between 1000°C and 1200°C takes place preferably in a protective-gas atmosphere.

10. Method according to one of claims 7 to 9, **characterized in that** after the conclusion of the CVD process, the coating (cover layer) is subjected to an additional mechanical smoothing treatment by means of abrasive brushes or by dry or wet blasting with fine blasting agents, preferably glass balls or corundum.

## Revendications

1. Insert de coupe destiné à l'enlèvement de copeaux, se composant d'un corps substrat en métal dur, en cermet ou en céramique avec un revêtement à plusieurs couches, dont la couche extérieure (couche de recouvrement) se compose d'une couche à une ou à plusieurs phase(s) en carbures, nitrures ou carbonitrures à base de Zr ou Hf, ou dont la couche extérieure est une couche à deux phases et se compose d'un carbure, d'un nitrure ou d'un carbonitrure du Zr ou Hf et ZrO₂, qui était appliquée au moyen du CVD et qui présente des contraintes internes de compression, et dont la couche ou bien les couches située(s) là-dessous appliquée(s) elle(s) aussi au moyen du CVD présente(nt) sans exception des contraintes internes de tension, au moins une couche située là-dessous ou la couche unique située là-dessous se composant de TiN, de TiC et/ou de Ti(C, N).

2. Insert de coupe selon la revendication 1, **caractérisé par le fait qu'**une couche se trouvant entre la couche de recouvrement et au moins une couche située près du corps substrat se compose d'Al₂O₃.

3. Insert de coupe selon la revendication 1 ou 2, **caractérisé par le fait que** la couche extérieure est une couche à phase unique et se compose d'un carbure, d'un nitrure ou d'un carbonitrure du Zr ou Hf ou d'un carbure, d'un nitrure ou d'un carbonitrure de la forme (M₁, M₂) (CₓN₁₋ₓ) avec M₁ = Zr ou Hf et M₂ = Ti, Hf, Nb et 0 ≤ x ≤ 1.

4. Insert de coupe selon l'une des revendications 1 à 3, **caractérisé par le fait que** la couche extérieure comprend une composition Me(CₓN₁₋ₓ) avec Me = Zr ou Hf et 0,3 ≤ x ≤ 0,7, de préférence la couche extérieure comprenant en sus en tant que deuxième phase du ZrO₂ avec une part relative comprise entre 15 et 60 % en masse.

5. Insert de coupe selon l'une des revendications 1 à 4, **caractérisé par le fait que** la couche de recouvrement présente une épaisseur d'au moins 2 µm et de 10 µm au maximum et/ou que l'épaisseur totale de la ou bien des couche(s) intérieure(s) soumise(s) à des contraintes de tension et de la ou bien des couche(s) extérieure(s) soumise(s) à des contraintes de compression est comprise entre 5 et 25 µm, de préférence entre 10 et 20 µm.

6. Insert de coupe selon l'une des revendications 1, 3 ou 5, **caractérisé par** une suite de couches déposée sur le corps substrat, de TiN avec une épaisseur allant jusqu'à 2 µm, de TiCN avec une épaisseur allant jusqu'à 5 µm et de la couche de recouvrement à phase unique ou à deux phases qui présente une épaisseur allant jusqu'à 5 µm.

7. Procédé de fabrication d'un insert de coupe selon l'une des revendications 1 à 6, **caractérisé par le fait que** le revêtement est appliqué par un processus CVD ininterrompu à des températures comprises entre 900°C et 1100°C par des changements respectifs des compositions de gaz.

8. Procédé de fabrication d'un insert de coupe se composant d'un corps substrat en métal dur, en cermet ou en céramique avec un revêtement à plusieurs couches, dont la couche extérieure se compose d'un carbonitrure multimétal à phase unique, qui est appliquée au moyen du CVD et qui présente des contraintes internes de compression, et dont la ou bien les couche(s) située(s) là-dessous appliquée(s) elle(s) aussi au moyen du CVD présente(nt) sans exception des contraintes internes de tension, dans lequel - après avoir déposé la couche extérieure - cette couche est soumise à un traitement thermique au-dessus de la dernière température de déposition CVD et au-dessous de la température eutectique du corps substrat pendant au moins 15 minutes, d'où résulte une ségrégation spinodale.

9. Procédé selon la revendication 8, **caractérisé par le fait que** le traitement thermique est réalisé entre 1000°C et 1200°C, de préférence dans une atmosphère contrôlée.

10. Procédé selon l'une des revendications 7 à 9, **caractérisé par le fait que**, après avoir terminé le processus CVD, le revêtement (couche de recouvrement) est soumis à un traitement supplémentaire mécanique lissant la surface, au moyen de brosses d'émeri ou par grenaillage sec ou humide avec des agents fins de grenaillage, de préférence en boules de verre ou corindon.
